# EUROPEAN PATENT SPECIFICATION

(11) **EP 4 557 621 B1**
(45) Date of publication and mention of the grant of the patent: **28.10.2026**
(21) Application number: 22956491.9
(22) Date of filing: 25.08.2022
(51) Int. Cl.: H03M 13/45, H03M 13/25, H03M 13/29, H04L 1/00, H03M 13/11

(54) **ERROR CORRECTION DECODING DEVICE AND ERROR CORRECTION DECODING METHOD**
FEHLERKORREKTURDECODIERUNGSVORRICHTUNG UND FEHLERKORREKTURDECODIERUNGSVERFAHREN
DISPOSITIF ET PROCÉDÉ DE DÉCODAGE DE CORRECTION D'ERREUR

(43) Date of publication of application: 21.05.2025
(73) Proprietor: MITSUBISHI ELECTRIC CORPORATION, Chiyoda-ku Tokyo 100-8310 (JP)
(72) Inventor: YOSHIDA, Tsuyoshi, Tokyo 100-8310 (JP)
(74) Representative: Plasseraud IP
(86) International application number: PCT/JP2022/031968
(87) International publication number: WO 2024/042664

(56) References cited:
- WO-A1-2018/042594
- WO-A1-2021/166203
- US-A1- 2020 044 770
- US-A1- 2021 359 707
- TSUYOSHI YOSHIDA, KOJI IGARASHI, MASASHI BIKAI, SHUN CHIKAMORI, KEISUKE MATSUDA, SHOTA KOSHIKAWA, GYO SUZUKI: "B-10-30 Low-power optical communication systems using multilevel encoded compressed PS", PROCEEDINGS OF THE 2021 IEICE GENERAL CONFERENCE, COMMUNICATION 2; MARCH 9-12, 2021, 1 January 2021 (2021-01-01) - 12 March 2021 (2021-03-12), JP, pages 188, XP009553084
- KAKIZAKI TAKESHI, NAKAMURA MASANORI, HAMAOKA FUKUTARO, KISAKA YOSHIAKI: "Low-complexity Channel-polarized Multilevel Coding for Probabilistic Amplitude Shaping", OPTICAL FIBER COMMUNICATION CONFERENCE (OFC) 2022, OPTICA PUBLISHING GROUP, WASHINGTON, D.C., 1 March 2022 (2022-03-01) - 10 March 2022 (2022-03-10), Washington, D.C., pages W3H.4, XP093143857, ISBN: 978-1-55752-466-9, DOI: 10.1364/OFC.2022.W3H.4

## Description

### TECHNICAL FIELD

The present disclosure relates to an error correction decoding device and an error correction decoding method.

### BACKGROUND ART

There is an error correction decoding device that decodes a multi-level modulation symbol in which the number of dimensions is D (D is an integer equal to or more than 1) and the number of bits per dimension is M (M is an integer equal to or more than 2) from D pulse amplitude modulation symbols (see, for example, Non Patent Literature 1).

The error correction decoding device includes a soft decision unit that calculates hard decision bits indicating positive and negative of a log posterior probability ratio of each bit included in the multi-level modulation symbol of the number of dimensions D by performing soft decision on the D pulse amplitude modulation symbols.

When the pulse amplitude modulation symbol is Nbit quantized per dimension, the number of coordinates after quantization on the reception side is 2^N^D. For example, if N = 6 and D = 4, the number of coordinates is 2^6^4 = 16,777,216.

### CITATION LIST

### NON PATENT LITERATURE

Non Patent Literature 1: T. Kakizaki et al., "Low-complexity Channelpolarized Multilevel Coding for Probabilistic Amplitude Shaping," Proc. OFC 2022, W3H.4.
WO 2021/166203 A1, US 2021/359707 A1 and US 2020/044770 A1 are relevant prior art, related to methods for probabilistic shaping in combination with channel encoding.

### SUMMARY OF INVENTION

### TECHNICAL PROBLEM

In the error correction decoding device disclosed in Non Patent Literature 1, as the number of dimensions D is larger, the calculation processing of each of a hard decision bit and reliability by the soft decision unit increases. As a result, there is a problem that it may take a lot of time for the soft decision unit to decode the multi-level modulation symbol.

If the soft decision unit has 2^N^D address spaces and includes a lookup table capable of storing the hard decision bit and the reliability corresponding to the value of the pulse amplitude modulation symbol of the number of dimensions D, each of the hard decision bit and the reliability corresponding to the value of the pulse amplitude modulation symbol can be obtained, but the address space included in the lookup table becomes larger as the number of dimensions D is larger. Therefore, depending on the number of dimensions D, the soft decision unit may not be able to implement the lookup table.

The present disclosure has been made to solve the above problems, and an object of the present disclosure is to obtain an error correction decoding device that can suppress an increase in calculation processing of each of a first hard decision bit and reliability due to an increase in the number of dimensions more than by the error correction decoding device disclosed in Non Patent Literature 1.

### SOLUTION TO PROBLEM

The invention is defined in the appended claims.

### ADVANTAGEOUS EFFECTS OF INVENTION

According to the present disclosure, it is possible to suppress an increase in calculation processing of each of a first hard decision bit and reliability due to an increase in the number of dimensions more than by the error correction decoding device disclosed in Non Patent Literature 1.

### BRIEF DESCRIPTION OF DRAWINGS

FIG. 1 is a configuration diagram illustrating an error correction decoding device according to a first embodiment.
FIG. 2 is a hardware configuration diagram illustrating hardware of the error correction decoding device according to the first embodiment.
FIG. 3 is a hardware configuration diagram of a computer in a case where the error correction decoding device is implemented by software, firmware, or the like.
FIG. 4 is a flowchart illustrating an error correction decoding method which is a processing procedure performed by the error correction decoding device.
FIG. 5 is a configuration diagram illustrating another error correction decoding device according to the first embodiment.
FIG. 6 is a hardware configuration diagram illustrating hardware of another error correction decoding device according to the first embodiment.
FIG. 7 is a configuration diagram illustrating another error correction decoding device according to the first embodiment.

### DESCRIPTION OF EMBODIMENTS

Hereinafter, in order to describe the present disclosure in more detail, modes for carrying out the present disclosure will be described with reference to the accompanying drawings.

### First Embodiment

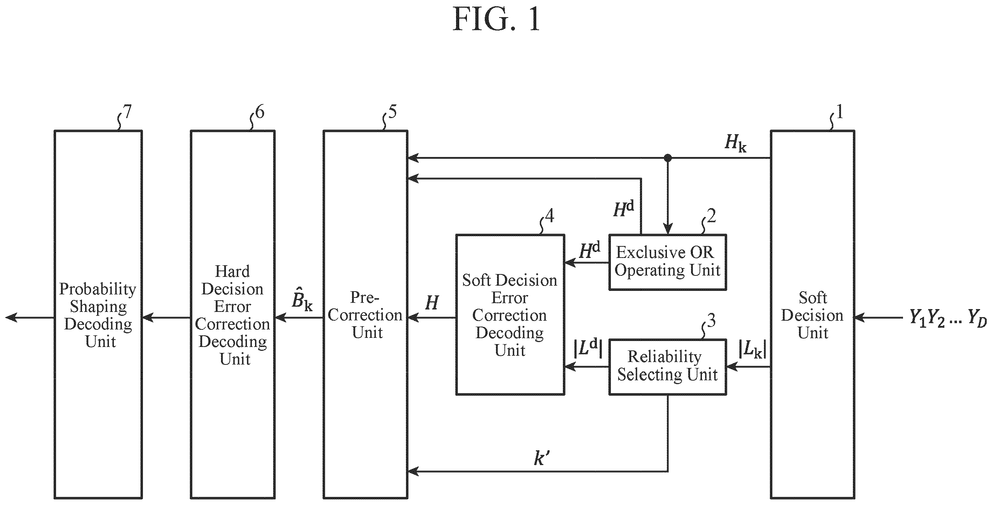

FIG. 1 is a configuration diagram illustrating an error correction decoding device according to a first embodiment.

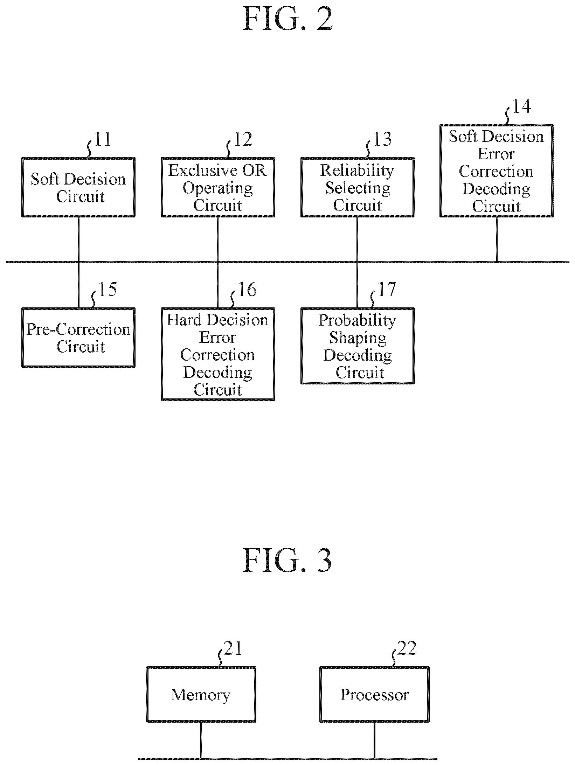

FIG. 2 is a hardware configuration diagram illustrating hardware of the error correction decoding device according to the first embodiment.

The error correction decoding device illustrated in FIG. 1 is implemented in a reception device, not illustrated, for example. The error correction decoding device illustrated in FIG. 1 includes a soft decision unit 1, an exclusive OR operating unit 2, a reliability selecting unit 3, a soft decision error correction decoding unit 4, a pre-correction unit 5, a hard decision error correction decoding unit 6, and a probability shaping decoding unit 7.

The error correction decoding device decodes a multi-level modulation symbol in which the number of dimensions is D (D is an integer equal to or more than 1) and the number of bits per dimension is M (M is an integer equal to or more than 2) from each of D pulse amplitude modulation symbols.

Since the reception device, not illustrated, includes the error correction decoding device illustrated in FIG. 1, it is possible to correct a bit error generated in a communication path with the transmission device, not illustrated.

The soft decision unit 1 is implemented by, for example, a soft decision circuit 11 illustrated in FIG. 2.

The soft decision unit 1 acquires each pulse amplitude modulation symbol Yⱼ (j = 1, ..., D) from the communication symbol sequence in which the D pulse amplitude modulation symbols Y₁, Y₂, ..., Y_{D} are arranged. The pulse amplitude modulation symbol Yⱼ is a one-dimensional pulse amplitude modulation symbol.

The soft decision unit 1 calculates, from the pulse amplitude modulation symbol Yⱼ, a first hard decision bit Hₖ indicating positive and negative of a log posterior probability ratio of each of the M bits included in the multi-level modulation symbol. The soft decision unit 1 performs a process of calculating M first hard decision bits Hₖ for D dimensions from one pulse amplitude modulation symbol Yⱼ. Thus, in Hₖ indicating the first hard decision bits collected for D dimensions, k = 1, 2, ..., D × M.

The soft decision unit 1 calculates the absolute value of each log posterior probability ratio as a first reliability |Lₖ|.

The soft decision unit 1 outputs the first hard decision bit Hₖ to each of the exclusive OR operating unit 2 and the pre-correction unit 5, and outputs the first reliability |Lₖ| to the reliability selecting unit 3.

The exclusive OR operating unit 2 is implemented by, for example, an exclusive OR operating circuit 12 illustrated in FIG. 2.

The exclusive OR operating unit 2 calculates the exclusive OR of the D × M first hard decision bits H₁ to H_{D×M} calculated by the soft decision unit 1.

The exclusive OR operating unit 2 outputs the operation result of the exclusive OR to each of the soft decision error correction decoding unit 4 and the pre-correction unit 5 as a second hard decision bit H^{d}.

The reliability selecting unit 3 is implemented by, for example, a reliability selecting circuit 13 illustrated in FIG. 2.

The reliability selecting unit 3 perform comparison of the D × M first reliabilities |L₁| to |L_{D×M}| calculated by the soft decision unit 1 with each other, and selects one first reliability from the D × M first reliabilities |L₁| to |L_{D×M}| on the basis of a result of the comparison.

On the basis of the comparison result, the reliability selecting unit 3 selects a minimum first reliability |Lₖ| among the D × M first reliabilities |L₁| to |L_{D×M}|, for example.

The reliability selecting unit 3 outputs the selected first reliability |Lₖ| to the soft decision error correction decoding unit 4 as a second reliability |L^{d}|.

Further, the reliability selecting unit 3 outputs an index k indicating the minimum first reliability |Lₖ| to the pre-correction unit 5 as a correction candidate index k'.

The soft decision error correction decoding unit 4 is implemented by, for example, a soft decision error correction decoding circuit 14 illustrated in FIG. 2.

The soft decision error correction decoding unit 4 acquires the second hard decision bit H^{d} from the exclusive OR operating unit 2 and acquires the second reliability |L^{d}| from the reliability selecting unit 3.

The soft decision error correction decoding unit 4 generates a third hard decision bit H by performing soft decision error correction decoding on the second hard decision bit H^{d} and the second reliability |L^{d}|.

The soft decision error correction decoding unit 4 outputs the third hard decision bit H to the pre-correction unit 5.

The pre-correction unit 5 is implemented by, for example, a pre-correction circuit 15 illustrated in FIG. 2.

The pre-correction unit 5 acquires the second hard decision bit H^{d} from the exclusive OR operating unit 2 and acquires the third hard decision bit H from the soft decision error correction decoding unit 4.

Further, the pre-correction unit 5 acquires the correction candidate index k' from the reliability selecting unit 3.

If the second hard decision bit H^{d} and the third hard decision bit H are the same, the pre-correction unit 5 outputs each of the D × M first hard decision bits H₁ to H_{D×M} acquired by the soft decision unit 1 to the hard decision error correction decoding unit 6 as a fourth hard decision bit B-hatₖ (k = 1, 2, ..., D × M). In the sentences of the specification, the symbol "^" cannot be added on the letter "B" due to the electronic application. Thus, it is expressed as "B-hat".

If the second hard decision bit H^{d} and the third hard decision bit H are different, the pre-correction unit 5 inverts the first hard decision bit Hₖ (k = k') corresponding to the correction candidate index k' among the D × M first hard decision bits H₁ to H_{D×M}. The first hard decision bit Hₖ (k = k') corresponding to the correction candidate index k' is the first hard decision bit Hₖ corresponding to the second reliability |L^{d}|.

The pre-correction unit 5 outputs the inverted first hard decision bit H_{k'} as a fourth hard decision bit B-hatₖ to the hard decision error correction decoding unit 6. The pre-correction unit 5 outputs the first hard decision bit Hₖ that is not inverted among the D × M first hard decision bits H₁ to H_{D×M} to the hard decision error correction decoding unit 6 as the fourth hard decision bit B-hatₖ as it is.

The hard decision error correction decoding unit 6 is implemented by, for example, a hard decision error correction decoding circuit 16 illustrated in FIG. 2.

The hard decision error correction decoding unit 6 generates a second restoration bit string as a bit string by performing hard decision error correction decoding on the D × M fourth hard decision bits B-hat₁ to B-hat_{D×M} output from the pre-correction unit 5.

The probability shaping decoding unit 7 is implemented by, for example, a probability shaping decoding circuit 17 illustrated in FIG. 2.

The probability shaping decoding unit 7 obtains a first restoration bit string by performing probability shaping decoding on the second restoration bit string generated by the hard decision error correction decoding unit 6.

Specifically, in the transmission device, in a case where a second bit string constituting the multi-level modulation symbol is obtained by performing probability shaping coding on the first bit string, the probability shaping decoding unit 7 performs probability shaping decoding on the second restoration bit string to obtain the first restoration bit string.

The probability shaping decoding unit 7 outputs the first restoration bit string to, for example, a processing unit of a reception device, not illustrated.

In FIG. 1, it is assumed that each of the soft decision unit 1, the exclusive OR operating unit 2, the reliability selecting unit 3, the soft decision error correction decoding unit 4, the pre-correction unit 5, the hard decision error correction decoding unit 6, and the probability shaping decoding unit 7, which are components of the error correction decoding device, is implemented by dedicated hardware as illustrated in FIG. 2. That is, it is assumed that the error correction decoding device is implemented by the soft decision circuit 11, the exclusive OR operating circuit 12, the reliability selecting circuit 13, the soft decision error correction decoding circuit 14, the pre-correction circuit 15, the hard decision error correction decoding circuit 16, and the probability shaping decoding circuit 17.

Each of the soft decision circuit 11, the exclusive OR operating circuit 12, the reliability selecting circuit 13, the soft decision error correction decoding circuit 14, the pre-correction circuit 15, the hard decision error correction decoding circuit 16, and the probability shaping decoding circuit 17 corresponds to, for example, a single circuit, a composite circuit, a programmed processor, a parallel-programmed processor, an application specific integrated circuit (ASIC), a field-programmable gate array (FPGA), or a combination thereof.

The components of the error correction decoding device are not limited to those implemented by dedicated hardware, and the error correction decoding device may be implemented by software, firmware, or a combination of software and firmware.

The software or firmware is stored in a memory of the computer as a program. The computer means hardware that executes a program, and corresponds to, for example, a central processing unit (CPU), a graphics processing unit (GPU), a processing unit, an arithmetic unit, a microprocessor, a microcomputer, a processor, or a digital signal processor (DSP).

FIG. 3 is a hardware configuration diagram of a computer in a case where the error correction decoding device is implemented by software, firmware, or the like.

In a case where the error correction decoding device is implemented by software, firmware, or the like, a program for causing a computer to execute respective processing procedures performed in the soft decision unit 1, the exclusive OR operating unit 2, the reliability selecting unit 3, the soft decision error correction decoding unit 4, the pre-correction unit 5, the hard decision error correction decoding unit 6, and the probability shaping decoding unit 7 is stored in the memory 21. Then, a processor 22 of the computer executes the program stored in the memory 21.

Furthermore, FIG. 2 illustrates an example in which each of the components of the error correction decoding device is implemented by dedicated hardware, and FIG. 3 illustrates an example in which the error correction decoding device is implemented by software, firmware, or the like. However, this is merely an example, and some components in the error correction decoding device may be implemented by dedicated hardware, and the remaining components may be implemented by software, firmware, or the like.

Next, an operation of the error correction decoding device illustrated in FIG. 1 will be described.

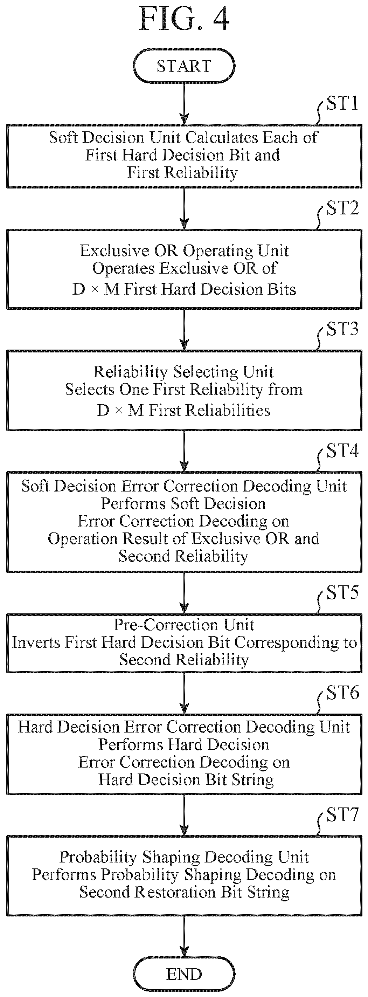

FIG. 4 is a flowchart illustrating an error correction decoding method which is a processing procedure performed by the error correction decoding device.

The soft decision unit 1 acquires each pulse amplitude modulation symbol Yⱼ (j = 1, ..., D) from the communication symbol sequence in which the D pulse amplitude modulation symbols Y₁, Y₂, ..., Y_{D} are arranged.

The soft decision unit 1 calculates a log posterior probability ratio L^{c}ₖ of each of the D × M bits included in the multi-level modulation symbol from the one-dimensional pulse amplitude modulation symbol Yⱼ as expressed in the following Expression (1). i = 1, ..., M, and M is an integer equal to or more than 2. k = D (i - 1) + j. The calculation processing of the log posterior probability ratio L^{c}ₖ is constant regardless of the number of dimensions D.${L}_{k}^{c} = ln \frac{{\sum }_{x ∈ χ : {b}_{i} = 0} {P}_{X} \left(x\right) {q}_{X , Y} \left(x, {Y}_{j}\right)}{{\sum }_{x ∈ χ : {b}_{i} = 1} {P}_{X} \left(x\right) {q}_{X , Y} \left(x, {Y}_{j}\right)}$ (1) ${q}_{X , Y} \left(x, y\right) ∝ exp \left(\frac{{\left|y-x\right|}^{2}}{2 {σ}^{2}}\right)$ (2)

In Expression (1), Y is a random variable representing the pulse amplitude modulation symbol Yⱼ. y is one of a set Y of D pulse amplitude modulation symbols Y₁, Y₂, ..., and Y_{D}. X is a random variable representing a multi-level modulation symbol output from the error correction decoding device illustrated in FIG. 1. Px(x) is a probability that X = x. x is one of a set X of multi-level modulation symbols.

i is a bit index for identifying a plurality of bits included in a 2^{M}-value multilevel modulation symbol. When the multi-level modulation symbol is, for example, 8 pulse amplitude modulation (8PAM), M = 3.

q_{X,Y}(x, y) is a decoding metric in a case where X = x and Y = y. In a one-dimensional additive white Gaussian noise (Additive White Gaussian Noise) communication path, it is expressed as Expression (2). σ is a standard deviation of noise.

"x ∈ X: bᵢ = 0" indicates a target of the sum, and specifically means that only those satisfying a condition that the bit bᵢ indicated by the bit index i is 0 are targets of the sum when taking the sum for x.

If the soft decision unit 1 includes the lookup table having 2^N address spaces and storing the log posterior probability ratio L^{c}ₖ corresponding to the value of the one-dimensional pulse amplitude modulation symbol Yⱼ, the soft decision unit 1 can obtain the log posterior probability ratio L^{c}ₖ corresponding to the value of the pulse amplitude modulation symbol Yⱼ from the lookup table without performing the operation of Expression (1). N is the number of bits representing the one-dimensional pulse amplitude modulation symbol Yⱼ quantized after being affected by noise or distortion in the communication path.

For example, when N = 6, y is represented by a value of 64. The address space of the LUT in this case is 64.

In the error correction decoding device disclosed in Non Patent Literature 1, when N = 6 and D = 2, y is represented by a value of 4096. The address space of the LUT in this case is 4096. Further, when N = 6 and D = 4, y is represented by a value of 16,777,216. The address space of the LUT in this case is 16,777,216.

As is clear from the difference in the address space of the LUT, the calculation amount of Expression (1) by the soft decision unit 1 is extremely smaller than the calculation amount of the log posterior probability ratio by the soft decision unit of the error correction decoding device disclosed in Non Patent Literature 1.

Next, the soft decision unit 1 calculates a first hard decision bit Hₖ indicating positive and negative of the log posterior probability ratio L^{c}ₖ of the bit bᵢ included in the multi-level modulation symbol (step ST1 in FIG. 4).

For example, the soft decision unit 1 sets the first hard decision bit Hₖ to 0 when the log posterior probability ratio L^{c}ₖ is positive, and sets the first hard decision bit Hₖ to 1 when the log posterior probability ratio L^{c}ₖ is negative.

The soft decision unit 1 outputs the first hard decision bit Hₖ to each of the exclusive OR operating unit 2 and the pre-correction unit 5.

The soft decision unit 1 calculates the absolute value of each log posterior probability ratio as the first reliability |Lₖ| (step ST1 in FIG. 4).

Specifically, the soft decision unit 1 calculates the absolute value of the log posterior probability ratio L^{c}ₖ as the first reliability |Lₖ|.

The soft decision unit 1 outputs the first reliability |Lₖ| to the reliability selecting unit 3.

The exclusive OR operating unit 2 acquires D × M first hard decision bits H₁ to H_{D×M} from the soft decision unit 1.

The exclusive OR operating unit 2 operates the exclusive OR of the D × M first hard decision bits H₁ to H_{D×M} as expressed in the following Expression (3) (step ST2 in FIG. 4).

The exclusive OR operating unit 2 outputs the operation result of the exclusive OR to each of the soft decision error correction decoding unit 4 and the pre-correction unit 5 as the second hard decision bit H^{d}.

In the error correction decoding device illustrated in FIG. 1, the exclusive OR operating unit 2 calculates the second hard decision bit H^{d} and outputs the second hard decision bit H^{d} to the pre-correction unit 5. However, this is merely an example, and the pre-correction unit 5 may calculate the second hard decision bit H^{d}. ${H}^{d} = \left({\sum }_{k = 1}^{D \times M} {H}_{k}\right) mod 2$ (3)

In Expression (3), "mod 2" is a mathematical symbol representing a remainder.

The reliability selecting unit 3 acquires D × M first reliabilities |L₁| to |L_{D×M}| from the soft decision unit 1, and compares the first reliabilities |L₁| to |L_{D×M}| with each other.

The reliability selecting unit 3 selects one first reliability from the D × M first reliabilities |L₁| to |L_{D×M}| on the basis of the comparison result (step ST3 in FIG. 4).

On the basis of the comparison result, the reliability selecting unit 3 selects the minimum first reliability |Lₖ| among the D × M first reliabilities |L₁| to |L_{D×M}|, for example.

The reliability selecting unit 3 outputs the selected first reliability |Lₖ| to the soft decision error correction decoding unit 4 as the second reliability |L^{d}|.

Here, an example is illustrated in which the reliability selecting unit 3 selects the minimum first reliability |Lₖ| among the D × M first reliabilities |L₁| to |L_{D×M}|. However, this is merely an example, and if there is no practical problem, the reliability selecting unit 3 may select, for example, the second smallest first reliability |Lₖ| among the D × M first reliabilities |L₁| to |L_{D×M}|.

The reliability selecting unit 3 specifies an index k indicating the selected first reliability |Lₖ| as the correction candidate index k' as expressed in the following Expression (4).

The reliability selecting unit 3 outputs the correction candidate index k' to the pre-correction unit 5. $k ′ = {arg min}_{k} \left|{L}_{k}\right|$ (4)

In Expression (4), "arg min" is a mathematical symbol indicating k that gives the minimum value of |Lₖ|.

The soft decision error correction decoding unit 4 acquires the second hard decision bit H^{d} from the exclusive OR operating unit 2 and acquires the second reliability |L^{d}| from the reliability selecting unit 3.

The soft decision error correction decoding unit 4 generates a third hard decision bit H by performing soft decision error correction decoding on the second hard decision bit H^{d} and the second reliability |L^{d}| (step ST4 in FIG. 4).

Specifically, the soft decision error correction decoding unit 4 generates a third hard decision bit H by performing soft decision error correction decoding on a plurality of second log posterior probability ratios configured by a combination of the second hard decision bit H^{d} and the second reliability |L^{d}|. Since the soft decision error correction decoding processing itself is a known technique, detailed description thereof will be omitted.

The soft decision error correction decoding unit 4 outputs the third hard decision bit H to the pre-correction unit 5.

As a soft decision error correction code, for example, a low density parity check code or a turbo code is used. The code length of the soft decision error correction code is about several 100 bits to several tens of thousands of bits. As the resolution per second log posterior probability ratio, for example, 8 values, 16 values, or 32 values are assumed.

The pre-correction unit 5 acquires the second hard decision bit H^{d} from the exclusive OR operating unit 2 and acquires the third hard decision bit H from the soft decision error correction decoding unit 4.

Further, the pre-correction unit 5 acquires D × M first hard decision bits H₁ to H_{D×M} from the soft decision unit 1, and acquires the correction candidate index k' from the reliability selecting unit 3.

The pre-correction unit 5 compares the second hard decision bit H^{d} with the third hard decision bit H.

If the second hard decision bit H^{d} and the third hard decision bit H are the same, the pre-correction unit 5 outputs the first hard decision bit Hₖ (k = 1, 2, ..., D × M) as the fourth hard decision bit B-hatₖ to the hard decision error correction decoding unit 6. In this case, the pre-correction unit 5 outputs the first hard decision bit Hₖ as it is to the hard decision error correction decoding unit 6 without inverting any of the first hard decision bits Hₖ.

If the second hard decision bit H^{d} and the third hard decision bit H are different, the pre-correction unit 5 inverts the first hard decision bit H_{k'} corresponding to the correction candidate index k' among the D × M first hard decision bits Hₖ to H_{D×M} (step ST5 in FIG. 4).

The pre-correction unit 5 outputs the inverted first hard decision bit H_{k'} as the fourth hard decision bit B-hatₖ (k = k') to the hard decision error correction decoding unit 6.

Further, the pre-correction unit 5 directly outputs the first hard decision bit Hₖ that is not inverted among the D × M first hard decision bits H₁ to H_{D×M} to the hard decision error correction decoding unit 6 as the fourth hard decision bit B-hatₖ as it is.

The processing of the pre-correction unit 5 is expressed as the following expressions (5) to (6). ${\hat{B}}_{k} = {H}_{k} \left(k\neq k′\right)$ (5) ${\hat{B}}_{k ′} = \left({H}_{k ′}+{H}^{d}+H\right) mod 2$ (6)

The hard decision error correction decoding unit 6 acquires D × M fourth hard decision bits B-hat₁ to B-hat_{D×M} from the pre-correction unit 5.

The hard decision error correction decoding unit 6 generates a second restoration bit string by performing hard decision error correction decoding on the D × M fourth hard decision bits B-hat₁ to B-hat_{D×M} (step ST6 in FIG. 4). Since the hard decision error correction decoding processing itself is a known technique, detailed description thereof will be omitted.

The hard decision error correction decoding unit 6 outputs the second restoration bit string to the probability shaping decoding unit 7.

As the hard decision error correction code, for example, a BCH code, a Staircase code, or a Zipper code can be used. The BCH code is disclosed in, for example, "R. Bose and D. Ray-Chaudhuri, "On a class of error correcting binary group codes," Information and Control, vol. 3, no. 1, pp. 68-79, March 1960". The Staircase code is disclosed in, for example, "B.P. Smith et al., "Staircase codes: FEC for 100 Gb/s OTN," J. Lightw. Technol., vol. 30, no. 1, pp. 110-117, Jan. 2012, doi: 10.1109/JLT. 2011.2175479". The Zipper code is disclosed in, for example, "A.Y. Sukmadji et al., "Zipper codes: Spatially-coupled product-like codes with iterative algebraic decoding," Canadian Workshop on Information Theory (CWIT), Hamilton, ON, Canada, June 2019, pp. 1-6, doi: 10.1109/CWIT. 2019.8929906".

The code length of the hard decision error correction code is, for example, several 100 bits to several 100,000 bits.

By rearranging the bit positions before the hard decision error correction decoding unit 6 performs hard decision error correction decoding, it is also possible to reduce the influence of continuous bit errors.

The probability shaping decoding unit 7 acquires the second restoration bit string from the hard decision error correction decoding unit 6.

The probability shaping decoding unit 7 obtains a first restoration bit string by performing probability shaping decoding on the second restoration bit string generated by the hard decision error correction decoding unit 6 (step ST7 in FIG. 4).

The probability shaping decoding unit 7 outputs the first restoration bit string to, for example, a processing unit of a reception device, not illustrated.

Yet, in a case where the second bit string constituting the multi-level modulation symbol is obtained by performing the probability shaping coding on the first bit string in such a manner that the occurrence probability of the plurality of signal points is biased by the transmission device transmitting the communication symbol sequence in which the D pulse amplitude modulation symbols Y₁, Y₂, ..., and Y_{D} are arranged, the probability shaping decoding unit 7 performs the probability shaping decoding on the second restoration bit string. Therefore, in the transmission device, if the second bit string is not obtained by performing the probability shaping coding on the first bit string, the probability shaping decoding unit 7 does not perform the probability shaping decoding on the second restoration bit string.

In the transmission device, for example, in a case where probability shaping coding is performed so that the probability distribution P_{X}(x) of the multi-level modulation symbol can be brought close to the discrete Gaussian distribution, the signal-to-noise ratio necessary to obtain the predetermined communication quality is reduced. Such probability shaping coding processing is disclosed in, for example, Patent Literature (WO 2020/031257 A).

In the first embodiment, an error correction decoding device that decodes a multi-level modulation symbol in which the number of dimensions is D (D is an integer equal to or more than 1) and the number of bits per dimension is M (M is an integer equal to or more than 2) from each of D pulse amplitude modulation symbols is configured. The error correction decoding device includes a soft decision unit 1 to acquire each of the pulse amplitude modulation symbols from a communication symbol sequence in which the D pulse amplitude modulation symbols are arranged, calculate a first hard decision bit indicating positive and negative of a log posterior probability ratio of each of M bits included in the multi-level modulation symbol from each of the pulse amplitude modulation symbols, and calculate an absolute value of each of log posterior probability ratios as a first reliability, and an exclusive OR operating unit 2 to operate an exclusive OR of D × M first hard decision bits calculated by the soft decision unit 1. Further, the error correction decoding device includes a reliability selecting unit 3 to perform comparison of D × M first reliabilities calculated by the soft decision unit 1 with each other, select one first reliability from the D × M first reliabilities on the basis of a result of the comparison, and output the one first reliability as a second reliability, and a soft decision error correction decoding unit 4 to perform soft decision error correction decoding on an operation result of the exclusive OR by the exclusive OR operating unit 2 and the second reliability. Therefore, the error correction decoding device can suppress an increase in calculation processing of each of a first hard decision bit and reliability due to an increase in the number of dimensions more than by the error correction decoding device disclosed in Non Patent Literature 1.

In the error correction decoding device illustrated in FIG. 1, the soft decision unit 1 acquires each of one-dimensional pulse amplitude modulation symbols from a communication symbol sequence in which the D pulse amplitude modulation symbols are arranged. However, the number of bits representing the one-dimensional pulse amplitude modulation symbol may be switched. In addition, the number of dimensions of the pulse amplitude modulation symbols acquired by the soft decision unit 1 may be switched.

In a case where such switching is performed, each processing in the exclusive OR operating unit 2, the reliability selecting unit 3, the soft decision error correction decoding unit 4, the pre-correction unit 5, and the hard decision error correction decoding unit 6 is affected. Yet, the influence on each processing can be handled, for example, by switching each of the bit index i handled in Expression (1) and a variable j for identifying the pulse amplitude modulation symbol.

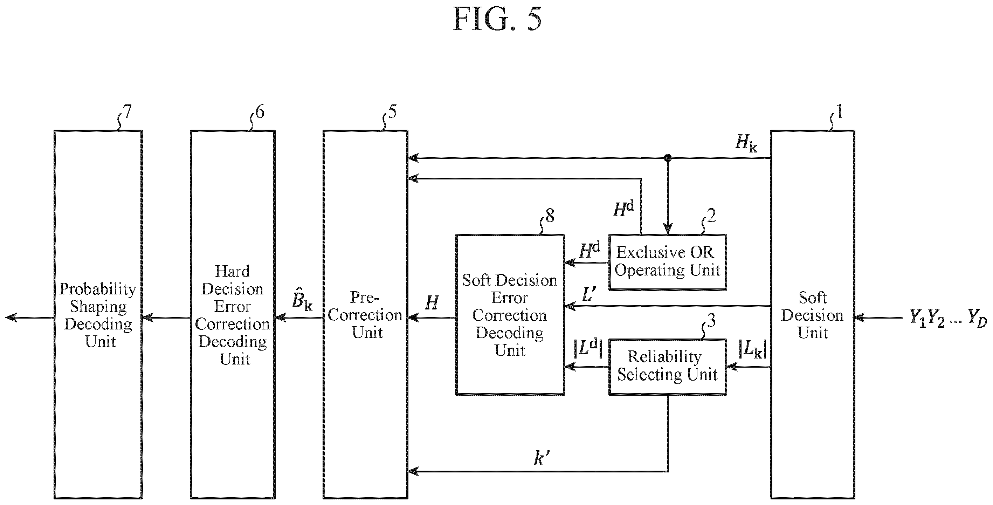

In a case where the bit bᵢ that is not related to calculation of the first hard decision bit Hₖ is present in the soft decision unit 1, the soft decision unit 1 outputs the log posterior probability ratio L^{c}ₖ for the bit bᵢ to the soft decision error correction decoding unit 8 as the first reliability L' as illustrated in FIG. 5. FIG. 5 is a configuration diagram illustrating another error correction decoding device according to the first embodiment. In FIG. 5, the same reference numerals as those in FIG. 1 denote the same or corresponding parts, and thus description thereof is omitted.

The soft decision error correction decoding unit 8 acquires the second hard decision bit H^{d} from the exclusive OR operating unit 2 and acquires the second reliability |L^{d}| from the reliability selecting unit 3.

The soft decision error correction decoding unit 4 generates a third hard decision bit H by performing soft decision error correction decoding on the second hard decision bit H^{d}, the second reliability |L^{d}|, and the first reliability L'.

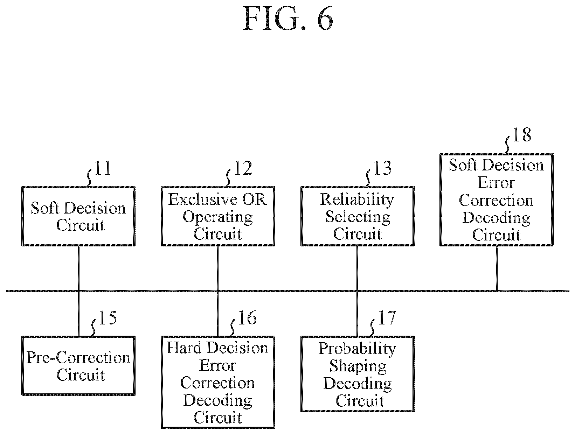

The soft decision error correction decoding unit 8 is implemented by a soft decision error correction decoding circuit 18, for example, as illustrated in FIG. 6.

FIG. 6 is a hardware configuration diagram illustrating hardware of another error correction decoding device according to the first embodiment. In FIG. 6, the same reference numerals as those in FIG. 2 denote the same or corresponding parts, and thus description thereof is omitted.

In the error correction decoding device illustrated in FIG. 1, the hard decision error correction decoding unit 6 generates a second restoration bit string by performing hard decision error correction decoding on the D × M fourth hard decision bits B-hat₁ to B-hat_{D×M} output from the pre-correction unit 5. However, this is merely an example, and the hard decision error correction decoding unit 6 may exclude some of the fourth hard decision bits B-hat₁ to B-hat_{D×M} output from the pre-correction unit 5 from the targets of hard decision error correction decoding.

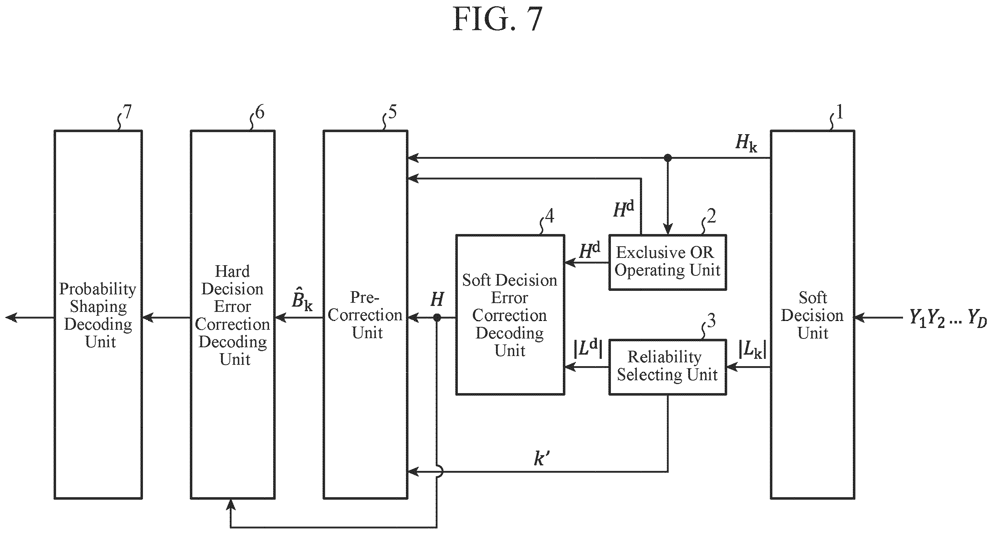

In this case, as illustrated in FIG. 7, the hard decision error correction decoding unit 6 acquires the third hard decision bit H corresponding to the fourth hard decision bit to be excluded from the soft decision error correction decoding unit 4 instead of the fourth hard decision bit to be excluded. FIG. 7 is a configuration diagram illustrating another error correction decoding device according to the first embodiment. In FIG. 7, the same reference numerals as those in FIG. 1 denote the same or corresponding parts.

Then, the hard decision error correction decoding unit 6 generates a second restoration bit string by performing hard decision error correction decoding on the fourth hard decision bits other than the fourth hard decision bits to be excluded and the third hard decision bit H corresponding to the fourth hard decision bits to be excluded among the fourth hard decision bits B-hat₁ to B-hat_{D×M}.

Note that, in the present disclosure, any component of the embodiment can be modified, or any component of the embodiment can be omitted.

### INDUSTRIAL APPLICABILITY

The present disclosure is suitable for an error correction decoding device and an error correction decoding method.

### REFERENCE SIGNS LIST

1: soft decision unit, 2: exclusive OR operating unit, 3: reliability selecting unit, 4: soft decision error correction decoding unit, 5: pre-correction unit, 6: hard decision error correction decoding unit, 7: probability shaping decoding unit, 8: soft decision error correction decoding unit, 11: soft decision circuit, 12: exclusive OR operating circuit, 13: reliability selecting circuit, 14: soft decision error correction decoding circuit, 15: pre-correction circuit, 16: hard decision error correction decoding circuit, 17: probability shaping decoding circuit, 18: soft decision error correction decoding circuit, 21: memory, 22: processor

## Claims

1. An error correction decoding device configured to decode D pulse amplitude modulation symbols, where D is an integer equal to or more than 1, and each pulse amplitude modulation symbol comprises M bits, where M is an integer equal to or more than 2, the error correction decoding device comprising:
a soft decision unit (1) configured to acquire each of the pulse amplitude modulation symbols from a communication symbol sequence in which the D pulse amplitude modulation symbols are arranged, calculate D × M first hard decision bits by calculating, for each of the D pulse amplitude modulation symbols, M first hard decision bits indicating positive and negative of a log posterior probability ratio of each one of the M bits included in said pulse amplitude modulation symbol, and calculate D × M first reliabilities, each being an absolute value of one of the log posterior probability ratios;
an exclusive OR operating unit (2) configured to operate an exclusive OR of the D × M first hard decision bits calculated by the soft decision unit to generate a second hard decision bit H^{d} indicating an operation result of the exclusive OR by the exclusive OR operating unit;
a reliability selecting unit (3) configured to perform a comparison of the D × M first reliabilities calculated by the soft decision unit with each other, select a minimum first reliability from the D × M first reliabilities on a basis of a result of the comparison, and output the minimum first reliability as a second reliability L^{d};
a third hard decision bit generating unit (4) configured to perform soft decision error correction decoding on the second hard decision bit H^{d} and the second reliability L^{d} to generate a third hard decision bit H,
wherein the error correction decoding device further comprises a pre-correction unit (5),
the pre-correction unit (5) being configured to output each of the D × M first hard decision bits calculated by the soft decision unit as D × M fourth hard decision bits when the second hard decision bit H^{d} indicating the operation result of the exclusive OR by the exclusive OR operating unit and the third hard decision bit H generated by performing soft decision error correction processing by the third hard decision bit generating unit are same, and
the pre-correction unit (5) being configured to invert a first hard decision bit corresponding to the second reliability L^{d} among the D × M first hard decision bits to obtain an inverted first hard decision bit, output the inverted first hard decision bit as a fourth hard decision bit, and output each of (D × M) - 1 first hard decision bits other than the first hard decision bit corresponding to the second reliability L^{d} among the D × M first hard decision bits as (D × M) - 1 fourth hard decision bits when the second hard decision bit H^{d} and the third hard decision bit H are different,
wherein the error correction decoding device further comprises a hard decision error correction processing unit (6) configured to generate a bit string by performing hard decision error correction processing on the D × M fourth hard decision bits output from the pre-correction unit, and
wherein the error correction decoding device further comprises a probability shaping decoding unit (7) configured to perform probability shaping decoding on the bit string generated by the hard decision error correction processing unit.

2. An error correction decoding method for decoding D pulse amplitude modulation symbols, where D is an integer equal to or more than 1, and each pulse amplitude modulation symbol comprises M bits, where M is an integer equal to or more than 2, the error correction decoding method comprising:
by a soft decision unit (1), acquiring each of the pulse amplitude modulation symbols from a communication symbol sequence in which the D pulse amplitude modulation symbols are arranged, calculating D × M first hard decision bits by calculating, for each of the D pulse amplitude modulation symbols, M first hard decision bits indicating positive and negative of a log posterior probability ratio of each one of the M bits included in said pulse amplitude modulation symbol, and calculating D × M first reliabilities, each being an absolute value of one of the log posterior probability ratios;
by an exclusive OR operating unit (2), operating an exclusive OR of the D × M first hard decision bits calculated by the soft decision unit to generate a second hard decision bit H^{d} indicating an operation result of the exclusive OR by the exclusive OR operating unit;
by a reliability selecting unit (3), performing comparison of the D × M first reliabilities calculated by the soft decision unit with each other, selecting a minimum first reliability from the D × M first reliabilities on a basis of a result of the comparison, and outputting the minimum first reliability as a second reliability L^{d};
by a third hard decision bit generating unit (4), performing soft decision error correction decoding on the second hard decision bit H^{d} and the second reliability L^{d} to generate a third hard decision bit H,
by a pre-correction unit (5), outputting each of the D × M first hard decision bits calculated by the soft decision unit as D × M fourth hard decision bits when the second hard decision bit H^{d} indicating the operation result of the exclusive OR by the exclusive OR operating unit and the third hard decision bit H generated by performing soft decision error correction processing by the soft decision error correction processing unit are same, and
by the pre-correction unit (5), inverting a first hard decision bit corresponding to the second reliability L^{d} among the D × M first hard decision bits to obtain an inverted first hard decision bit, outputting the inverted first hard decision bit as a fourth hard decision bit, and outputting each of (D × M) - 1 first hard decision bits other than the first hard decision bit corresponding to the second reliability L^{d} among the D × M first hard decision bits as (D × M) - 1 fourth hard decision bits when the second hard decision bit H^{d} and the third hard decision bit H are different,
by a hard decision error correction processing unit (6), generating a bit string by performing hard decision error correction processing on the D × M fourth hard decision bits output from the pre-correction unit, and
by a probability shaping decoding unit (7), performing probability shaping decoding on the bit string generated by the hard decision error correction processing unit.

## Patentansprüche

1. Fehlerkorrektur-Decodiervorrichtung, die konfiguriert ist, um D Pulsamplitudenmodulationssymbole zu decodieren, wobei D eine ganze Zahl gleich oder größer als 1 ist, und jedes Pulsamplitudenmodulationssymbol M Bits umfasst, wobei M eine ganze Zahl gleich oder größer als 2 ist, wobei die Fehlerkorrektur-Decodiervorrichtung umfasst:
eine Soft-Decision-Einheit (1), die konfiguriert ist, um jedes der Pulsamplitudenmodulationssymbole aus einer Kommunikationssymbolsequenz zu erfassen, in der die D Pulsamplitudenmodulationssymbole angeordnet sind, D × M erste Hard-Decision-Bits zu berechnen, indem für jedes der D Pulsamplitudenmodulationssymbole M erste Hard-Decision-Bits berechnet werden, die ein Positiv und Negativ eines logarithmischen a posteriori Wahrscheinlichkeitsverhältnisses jedes der M in dem Pulsamplitudenmodulationssymbol enthaltenen Bits angeben, und D × M erste Zuverlässigkeiten zu berechnen, die jeweils ein Absolutwert eines der logarithmischen a posteriori Wahrscheinlichkeitsverhältnisse sind;
eine Exklusiv-ODER-Betriebseinheit (2), die konfiguriert ist, um ein Exklusiv-ODER der D × M ersten Hard-Decision-Bits, die von der Soft-Decision-Einheit berechnet wurden, zu betreiben, um ein zweites Hard-Decision-Bit H^{d} zu erzeugen, das ein Betriebsergebnis des Exklusiv-ODER durch die Exklusiv-ODER-Betriebseinheit anzeigt;
eine Zuverlässigkeitsauswahleinheit (3), die konfiguriert ist, um einen Vergleich der D × M ersten Zuverlässigkeiten, die von der Soft-Decision-Einheit berechnet wurden, miteinander durchzuführen, eine minimale erste Zuverlässigkeit aus den D × M ersten Zuverlässigkeiten auf der Grundlage eines Ergebnisses des Vergleichs auszuwählen und die minimale erste Zuverlässigkeit als eine zweite Zuverlässigkeit L^{d} auszugeben;
eine Erzeugungseinheit für ein drittes Hard-Decision-Bit (4), die konfiguriert ist, um eine Soft-Decision-Fehlerkorrektur-Decodierung an dem zweiten Hard-Decision-Bit H^{d} und der zweiten Zuverlässigkeit L^{d} durchzuführen, um ein drittes Hard-Decision-Bit H zu erzeugen,
wobei die Fehlerkorrektur-Decodiervorrichtung ferner eine Vorkorrektureinheit (5) umfasst,
wobei die Vorkorrektureinheit (5) konfiguriert ist, um jedes der D × M ersten Hard-Decision-Bits, die von der Soft-Decision-Einheit berechnet wurden, als D × M vierte Hard-Decision-Bits auszugeben, wenn das zweite Hard-Decision-Bit H^{d}, das das Betriebsergebnis des Exklusiv-ODER durch die Exklusiv-ODER-Betriebseinheit anzeigt, und das dritte Hard-Decision-Bit H, das durch Durchführen einer Soft-Decision-Fehlerkorrekturverarbeitung durch die Erzeugungseinheit für ein drittes Hard-Decision-Bit erzeugt wird, gleich sind, und
wobei die Vorkorrektureinheit (5) konfiguriert ist, um ein erstes Hard-Decision-Bit, das der zweiten Zuverlässigkeit L^{d} unter den D × M ersten Hard-Decision-Bits entspricht, zu invertieren, um ein invertiertes erstes Hard-Decision-Bit zu erhalten, das invertierte erste Hard-Decision-Bit als ein viertes Hard-Decision-Bit auszugeben, und jedes der (D × M) - 1 ersten Hard-Decision-Bits, die nicht dem ersten Hard-Decision-Bit entsprechen, das der zweiten Zuverlässigkeit L^{d} unter den D × M ersten Hard-Decision-Bits entspricht, als (D × M) - 1 vierte Hard-Decision-Bits auszugeben, wenn das zweite Hard-Decision-Bit H^{d} und das dritte Hard-Decision-Bit H unterschiedlich sind,
wobei die Fehlerkorrektur-Decodiervorrichtung ferner eine Hard-Decision-Fehlerkorrektur-Verarbeitungseinheit (6) umfasst, die konfiguriert ist, um eine Bitkette durch Durchführen einer Hard-Decision-Fehlerkorrekturverarbeitung an den D × M vierten Hard-Decision-Bits, die von der Vorkorrektureinheit ausgegeben werden, zu erzeugen, und
wobei die Fehlerkorrektur-Decodiervorrichtung ferner eine Wahrscheinlichkeitsformungs-Decodiereinheit (7) umfasst, die konfiguriert ist, um eine Wahrscheinlichkeitsformungs-Decodierung an der Bitkette durchzuführen, die von der Hard-Decision-Fehlerkorrektur-Verarbeitungseinheit erzeugt wird.

2. Fehlerkorrektur-Decodierverfahren zum Decodieren von D Pulsamplitudenmodulationssymbolen, wobei D eine ganze Zahl gleich oder größer als 1 ist, und jedes Pulsamplitudenmodulationssymbol M Bits umfasst, wobei M eine ganze Zahl gleich oder größer als 2 ist, wobei das Fehlerkorrektur-Decodierverfahren umfasst:
mittels einer Soft-Decision-Einheit (1), Erfassen jedes der Pulsamplitudenmodulationssymbole aus einer Kommunikationssymbolsequenz, in der die D Pulsamplitudenmodulationssymbole angeordnet sind, Berechnen von D × M ersten Hard-Decision-Bits durch Berechnen, für jedes der D Pulsamplitudenmodulationssymbole, von M ersten Hard-Decision-Bits, die ein Positiv und Negativ eines logarithmischen a posteriori Wahrscheinlichkeitsverhältnisses jedes der M in dem Pulsamplitudenmodulationssymbol enthaltenen Bits angeben, und Berechnen von D × M ersten Zuverlässigkeiten, die jeweils ein Absolutwert eines der logarithmischen a posteriori Wahrscheinlichkeitsverhältnisse sind;
mittels einer Exklusiv-ODER-Betriebseinheit (2), Betreiben eines Exklusiv-ODER der D × M ersten Hard-Decision-Bits, die von der Soft-Decision-Einheit berechnet wurden, um ein zweites Hard-Decision-Bit H^{d} zu erzeugen, das ein Betriebsergebnis des Exklusiv-ODER durch die Exklusiv-ODER-Betriebseinheit anzeigt;
mittels einer Zuverlässigkeitsauswahleinheit (3), Durchführen eines Vergleichs der D × M ersten Zuverlässigkeiten, die von der Soft-Decision-Einheit berechnet wurden, miteinander, Auswählen einer minimalen ersten Zuverlässigkeit aus den D × M ersten Zuverlässigkeiten auf der Grundlage eines Ergebnisses des Vergleichs, und Ausgeben der minimalen ersten Zuverlässigkeit als eine zweite Zuverlässigkeit L^{d};
mittels einer Erzeugungseinheit für ein drittes Hard-Decision-Bit (4), Durchführen einer Soft-Decision-Fehlerkorrektur-Decodierung an dem zweiten Hard-Decision-Bit H^{d} und der zweiten Zuverlässigkeit L^{d}, um ein drittes Hard-Decision-Bit H zu erzeugen,
mittels einer Vorkorrektureinheit (5), Ausgeben jedes der D × M ersten Hard-Decision-Bits, die von der Soft-Decision-Einheit berechnet wurden, als D × M vierte Hard-Decision-Bits, wenn das zweite Hard-Decision-Bit H^{d}, das das Betriebsergebnis des Exklusiv-ODER durch die Exklusiv-ODER-Betriebseinheit anzeigt, und das dritte Hard-Decision-Bit H, das durch Durchführen einer Soft-Decision-Fehlerkorrekturverarbeitung durch die Soft-Decision-Fehlerkorrektur-Verarbeitungseinheit erzeugt wird, gleich sind, und
mittels der Vorkorrektureinheit (5), Invertieren eines ersten Hard-Decision-Bits, das der zweiten Zuverlässigkeit L^{d} unter den D × M ersten Hard-Decision-Bits entspricht, um ein invertiertes erstes Hard-Decision-Bit zu erhalten, Ausgeben des invertierten ersten Hard-Decision-Bits als ein viertes Hard-Decision-Bit, und Ausgeben jedes der (D × M) - 1 ersten Hard-Decision-Bits, die nicht dem ersten Hard-Decision-Bit entsprechen, das der zweiten Zuverlässigkeit L^{d} unter den D × M ersten Hard-Decision-Bits entspricht, als (D × M) - 1 vierte Hard-Decision-Bits, wenn das zweite Hard-Decision-Bit H^{d} und das dritte Hard-Decision-Bit H unterschiedlich sind,
mittels einer Hard-Decision-Fehlerkorrektur-Verarbeitungseinheit (6), Erzeugen einer Bitkette durch Durchführen einer Hard-Decision-Fehlerkorrekturverarbeitung an den D × M vierten Hard-Decision-Bits, die von der Vorkorrektureinheit ausgegeben werden, und
mittels einer Wahrscheinlichkeitsformungs-Decodiereinheit (7), Durchführen einer Wahrscheinlichkeitsformungs-Decodierung an der Bitkette, die von der Hard-Decision-Fehlerkorrektur-Verarbeitungseinheit erzeugt wird.

## Revendications

1. Dispositif de décodage à correction d'erreur configuré pour décoder D symboles de modulation d'amplitude d'impulsion, où D est un entier égal ou supérieur à 1, et chaque symbole de modulation d'amplitude d'impulsion comprend M bits, où M est un entier égal ou supérieur à 2, le dispositif de décodage à correction d'erreur comprenant :
une unité de décision souple (1) configurée pour acquérir chacun des symboles de modulation d'amplitude d'impulsion à partir d'une séquence de symboles de communication dans laquelle les D symboles de modulation d'amplitude d'impulsion sont agencés, calculer D × M premiers bits de décision dure en calculant, pour chacun des D symboles de modulation d'amplitude d'impulsion, M premiers bits de décision dure indiquant le positif et le négatif d'un rapport de probabilité a posteriori logarithmique de chacun des M bits inclus dans ledit symbole de modulation d'amplitude d'impulsion, et calculer D × M premières fiabilités, chacune étant une valeur absolue de l'un des rapports de probabilité a posteriori logarithmiques ;
une unité d'opération OU exclusif (2) configurée pour effectuer une opération OU exclusif des D × M premiers bits de décision dure calculés par l'unité de décision souple pour générer un deuxième bit de décision dure H^{d} indiquant un résultat d'opération du OU exclusif par l'unité d'opération OU exclusif ;
une unité de sélection de fiabilité (3) configurée pour effectuer une comparaison des D × M premières fiabilités calculées par l'unité de décision souple les unes avec les autres, sélectionner une première fiabilité minimale parmi les D × M premières fiabilités sur la base d'un résultat de la comparaison, et délivrer en sortie la première fiabilité minimale en tant que deuxième fiabilité L^{d} ;
une unité de génération de troisième bit de décision dure (4) configurée pour effectuer un décodage à correction d'erreur à décision souple sur le deuxième bit de décision dure H^{d} et la deuxième fiabilité L^{d} pour générer un troisième bit de décision dure H,
dans lequel le dispositif de décodage à correction d'erreur comprend en outre une unité de pré-correction (5),
l'unité de pré-correction (5) étant configurée pour délivrer en sortie chacun des D × M premiers bits de décision dure calculés par l'unité de décision souple en tant que D × M quatrièmes bits de décision dure lorsque le deuxième bit de décision dure H^{d} indiquant le résultat de l'opération du OU exclusif par l'unité d'opération OU exclusif et le troisième bit de décision dure H généré en effectuant un traitement de correction d'erreur à décision souple par l'unité de génération de troisième bit de décision dure sont identiques, et
l'unité de pré-correction (5) étant configurée pour inverser un premier bit de décision dure correspondant à la deuxième fiabilité L^{d} parmi les D × M premiers bits de décision dure pour obtenir un premier bit de décision dure inversé, délivrer en sortie le premier bit de décision dure inversé en tant qu'un quatrième bit de décision dure, et délivrer en sortie chacun des (D × M) - 1 premiers bits de décision dure autres que le premier bit de décision dure correspondant à la deuxième fiabilité L^{d} parmi les D × M premiers bits de décision dure en tant que (D × M) - 1 quatrièmes bits de décision dure lorsque le deuxième bit de décision dure H^{d} et le troisième bit de décision dure H sont différents,
dans lequel le dispositif de décodage à correction d'erreur comprend en outre une unité de traitement de correction d'erreur à décision dure (6) configurée pour générer une chaîne de bits en effectuant un traitement de correction d'erreur à décision dure sur les D × M quatrièmes bits de décision dure délivrés en sortie par l'unité de pré-correction, et
dans lequel le dispositif de décodage à correction d'erreur comprend en outre une unité de décodage de mise en forme de probabilité (7) configurée pour effectuer un décodage de mise en forme de probabilité sur la chaîne de bits générée par l'unité de traitement de correction d'erreur à décision dure.

2. Procédé de décodage à correction d'erreur pour décoder D symboles de modulation d'amplitude d'impulsion, où D est un entier égal ou supérieur à 1, et chaque symbole de modulation d'amplitude d'impulsion comprend M bits, où M est un entier égal ou supérieur à 2, le procédé de décodage à correction d'erreur comprenant :
par une unité de décision souple (1), l'acquisition de chacun des symboles de modulation d'amplitude d'impulsion à partir d'une séquence de symboles de communication dans laquelle les D symboles de modulation d'amplitude d'impulsion sont agencés, le calcul de D × M premiers bits de décision dure en calculant, pour chacun des D symboles de modulation d'amplitude d'impulsion, M premiers bits de décision dure indiquant le positif et le négatif d'un rapport de probabilité a posteriori logarithmique de chacun des M bits inclus dans ledit symbole de modulation d'amplitude d'impulsion, et le calcul de D × M premières fiabilités, chacune étant une valeur absolue de l'un des rapports de probabilité a posteriori logarithmiques ;
par une unité d'opération OU exclusif (2), l'opération d'un OU exclusif des D × M premiers bits de décision dure calculés par l'unité de décision souple pour générer un deuxième bit de décision dure H^{d} indiquant un résultat d'opération du OU exclusif par l'unité d'opération OU exclusif ;
par une unité de sélection de fiabilité (3), l'exécution d'une comparaison des D × M premières fiabilités calculées par l'unité de décision souple les unes avec les autres, la sélection d'une première fiabilité minimale parmi les D × M premières fiabilités sur la base d'un résultat de la comparaison, et la sortie de la première fiabilité minimale en tant que deuxième fiabilité L^{d} ;
par une unité de génération de troisième bit de décision dure (4), l'exécution d'un décodage à correction d'erreur à décision souple sur le deuxième bit de décision dure H^{d} et la deuxième fiabilité L^{d} pour générer un troisième bit de décision dure H,
par une unité de pré-correction (5), la sortie de chacun des D × M premiers bits de décision dure calculés par l'unité de décision souple en tant que D × M quatrièmes bits de décision dure lorsque le deuxième bit de décision dure H^{d} indiquant le résultat de l'opération du OU exclusif par l'unité d'opération OU exclusif et le troisième bit de décision dure H généré en effectuant un traitement de correction d'erreur à décision souple par l'unité de traitement de correction d'erreur à décision souple sont identiques, et
par l'unité de pré-correction (5), l'inversion d'un premier bit de décision dure correspondant à la deuxième fiabilité L^{d} parmi les D × M premiers bits de décision dure pour obtenir un premier bit de décision dure inversé, la sortie du premier bit de décision dure inversé en tant qu'un quatrième bit de décision dure, et la sortie de chacun des (D × M) - 1 premiers bits de décision dure autres que le premier bit de décision dure correspondant à la deuxième fiabilité L^{d} parmi les D × M premiers bits de décision dure en tant que (D × M) - 1 quatrièmes bits de décision dure lorsque le deuxième bit de décision dure H^{d} et le troisième bit de décision dure H sont différents,
par une unité de traitement de correction d'erreur à décision dure (6), la génération d'une chaîne de bits en effectuant un traitement de correction d'erreur à décision dure sur les D × M quatrièmes bits de décision dure délivrés en sortie par l'unité de pré-correction, et
par une unité de décodage de mise en forme de probabilité (7), l'exécution d'un décodage de mise en forme de probabilité sur la chaîne de bits générée par l'unité de traitement de correction d'erreur à décision dure.
